# FASCICULE DE BREVET EUROPEEN

(11) **EP 0 869 522 B1**
(45) Date de publication et mention de la délivrance du brevet: **23.01.2002**
(21) Numéro de dépôt: 98400725.2
(22) Date de dépôt: 25.03.1998
(51) Int. Cl.: H01H 9/16

(54) **Organe de signalisation à diode électroluminescente**
Anzeigeorgan mit lichtemittierender Diode
Signalling device with light emitting diode

(30) Priorité: 04.04.1997 FR 9704251
(43) Date de publication de la demande: 07.10.1998
(73) Titulaire: Schneider Electric Industries SA, 92500 Rueil-Malmaison (FR)
(72) Inventeur: Chauvet, Francis, 16440 Moutiers (FR); Raffoux, Philippe, 16430 Champniers (FR)

(56) Documents cités:
- WO-A-86/06872
- DE-U- 9 200 772
- FR-A- 2 652 433

## Description

La présente invention concerne un organe de signalisation tel qu'un voyant ou un bouton-poussoir lumineux, comprenant un corps doté d'un axe longitudinal et terminé par une tête qui présente un organe translucide d'où sort un faisceau lumineux utile, ainsi qu'un circuit imprimé portant une diode électroluminescente qui engendre un faisceau d'émission produisant le faisceau utile. Un tel organe est décrit par exemple dans FR-A-2 652 433.

Il est connu de réaliser des voyants munis d'une diode électroluminescente montée sur un circuit imprimé qui porte par ailleurs divers composants propres à un circuit d'alimentation de la diode ; la diode électroluminescente est généralement disposée en bout du circuit imprimé, sur la tranche de celui-ci, de façon que le faisceau d'émission de la diode soit dirigé selon un axe parallèle au plan du circuit imprimé. Ce mode de montage ne convient cependant pas si l'on utilise une diode prévue pour être montée en surface (CMS). Il est également connu de disposer une diode électroluminescente CMS sur un circuit imprimé avec sa surface d'émission dirigée pour que le faisceau émis reste parallèle au plan du circuit. Il est a priori désavantageux de disposer la diode électroluminescente d'une manière différente, car l'énergie du faisceau utile résultant est alors diminuée.

De plus, il est difficile d'utiliser une disposition commune pour des voyants et pour des boutons-poussoirs lumineux. On observe en effet, puisque la paroi diffuseuse de lumière des boutons-poussoirs est essentiellement mobile, un écart fâcheux de luminosité entre des organes de signalisation juxtaposés tels que des voyants et des boutons-poussoirs lumineux et une hétérogénéité dans l'aspect de ces organes.

L'invention a pour but de structurer un organe de signalisation tel qu'un voyant ou un bouton-poussoir lumineux de façon que le faisceau lumineux utile obtenu avec cet organe soit extrêmement homogène et permette notamment de disposer plusieurs tels organes en voisinage mutuel sans hétérogénéité d'aspect.

Selon l'invention, la diode électroluminescente est montée latéralement en surface sur un côté du circuit imprimé de manière que son faisceau d'émission soit dirigé selon une direction sensiblement perpendiculaire à l'axe longitudinal du corps, et le corps présente une partie de forme générale tubulaire dotée, à l'intérieur et en regard de la diode latérale, d'une surface de réflexion évasée non polie.

La diffusion de lumière ainsi obtenue est très homogène et en particulier diffère peu entre un voyant et un bouton-poussoir lumineux équipés du même dispositif, tout en évitant la concentration du flux lumineux en un point situé au centre de l'organe translucide qui doit assurer la diffusion de lumière.

De préférence, la diode électroluminescente est montée au voisinage immédiat de l'extrémité du circuit imprimé située en regard de la surface évasée non polie, de manière que la partie du circuit imprimé située entre son extrémité et la diode n'altère pas le flux transmis.

La description va être faite ci-après d'un mode de réalisation de l'invention, à titre d'exemple et en regard des dessins annexés.

La figure 1 montre en élévation un voyant à diode électroluminescente conforme à l'invention.

La figure 2 représente une vue en coupe axiale agrandie du voyant de la figure 1.

L'organe de signalisation illustré sur les figures est un voyant 10 qui comprend une tête 11 munie d'un organe translucide 12 qui assure la diffusion de lumière et un corps 13 en matière plastique opaque de forme générale tubulaire d'axe longitudinal X-X' ; l'organe translucide 12 comporte une paroi translucide 12a assurant la diffusion de lumière et un cabochon coloré 12b qui recouvre la paroi 12a et est transparent ou translucide. Le corps 13 est de forme cylindrique, mais pourrait également être de forme parallélépipédique.

La tête 11 est destinée à être apparente au-dessus d'une paroi 14 de montage du voyant, tandis que le corps 13 sert d'une part à la fixation du voyant et d'autre part à loger des moyens de connexion et d'alimentation de la diode ; le corps 13 est inséré dans un orifice de la paroi 14 et il est fixé contre celle-ci, par exemple au moyen d'une partie filetée 13a avec laquelle coopère un écrou 15. Les moyens de connexion et d'alimentation comprennent des éléments de connexion externe 16, par exemple des fiches ou des bornes à vis ou élastiques, et un circuit d'alimentation dont les composants sont portés par un circuit imprimé 20.

Selon l'invention, la diode électroluminescente 21 est un composant monté en surface (CMS) sur le circuit imprimé 20 du même côté 20a de ce circuit que des composants 22 de son circuit d'alimentation. La diode électroluminescente 21 est située au voisinage immédiat de l'extrémité supérieure 20b du circuit imprimé 20, au niveau d'une surface évasée 17 du corps, à une hauteur h de la directrice initiale 17a de cette surface qui à l'opposé de l'organe diffuseur translucide 12.

Le circuit imprimé 20 peut être aligné avec l'axe longitudinal de symétrie X-X' du voyant ou en être légèrement écarté, avec émission par la diode électroluminescente latérale 21 d'un faisceau F1 selon un axe moyen Y-Y' sensiblement perpendiculaire à l'axe X-X'; la hauteur h de la diode et de son axe moyen d'émission Y-Y' par rapport à la directrice 17a est déterminée pour permettre un bon renvoi, vers l'avant du voyant, du faisceau F1 par réflexions multiples sur la surface 17.

La surface 17 du corps 13 - ou d'une pièce réfléchissante rapportée au corps 13-située en regard de la diode 21 est non polie, voire dépolie, de manière à obtenir un état de surface lambertien, c'est-à-dire favorisant les réflexions du faisceau F1.

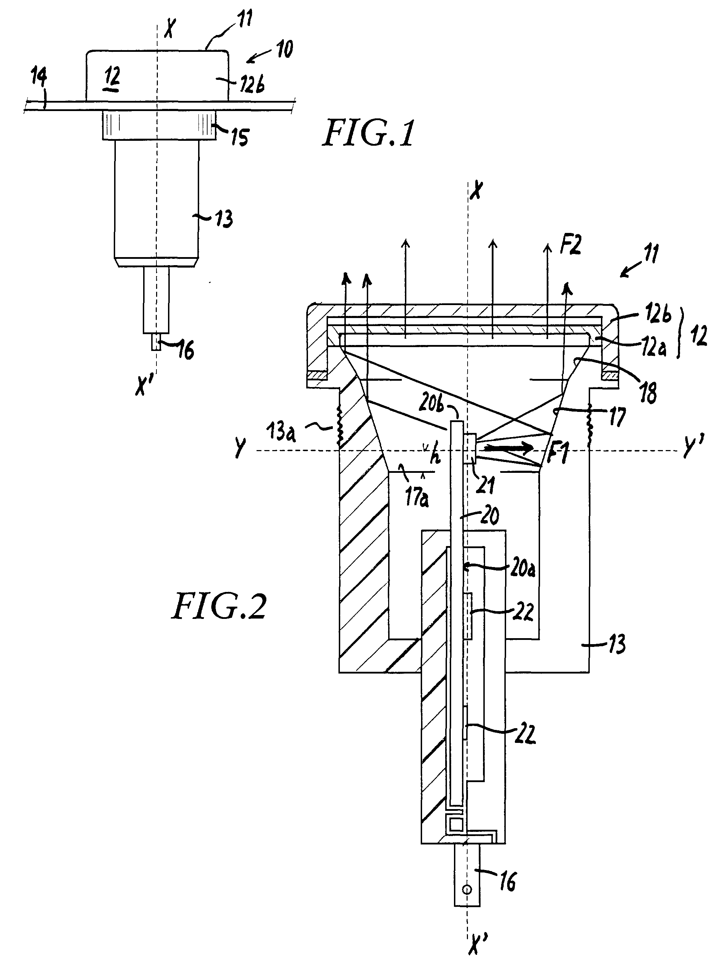

Comme on le voit figure 2, le faisceau F1 subit des réflexions multiples en premier lieu sur la surface évasée 17, avec une très faible déperdition à travers la paroi latérale du corps 13, puis en second lieu sur une partie de surface 18 qui est connexe à la surface évasée 17 et dont l'évasement est plus marqué, pour sortir du voyant via l'organe 12, c'est-à-dire avec diffusion via la paroi de diffusion translucide 12a puis transmission via la paroi antérieure du cabochon 12b sous forme d'un faisceau utile F2. Le diffuseur et/ou le cabochon est coloré d'une manière appropriée à la longueur d'onde émise par la diode.

L'invention s'applique aussi à des organes de signalisation dont l'organe translucide ou le cabochon est mobile selon la direction longitudinale X-X' du corps. On constate avec les organes de signalisation décrits l'absence de point lumineux au centre du cabochon et une très bonne homogénéité de l'aspect lumineux de voyants et boutons-poussoirs conformes à l'invention quand on les juxtapose ou qu'on les dispose au voisinage les uns des autres.

## Revendications

1. Organe de signalisation tel qu'un voyant ou un bouton-poussoir lumineux, comprenant un corps (13) doté d'un axe longitudinal (X-X') et terminé par une tête (11) qui présente un organe diffuseur translucide (12) d'où sort un faisceau lumineux utile (F2), ainsi qu'un circuit imprimé (20) portant une diode électroluminescente (21) qui engendre un faisceau d'émission (F1) produisant le faisceau utile,
***caractérisé par le fait que** :*
- la diode électroluminescente (21) est montée latéralement en surface sur un côté (20a) du circuit imprimé (20) de manière que la direction (Y-Y') de son faisceau d'émission (F1) soit sensiblement perpendiculaire à l'axe longitudinal (X-X') du corps (13),
- le corps (13) présente une partie de forme générale tubulaire dotée, à l'intérieur et en regard de la diode latérale (21), d'une surface évasée non polie (17).

2. Organe de signalisation selon la revendication 1, **caractérisé par le fait que** la diode électroluminescente (21) est montée sur le circuit imprimé (20) au voisinage immédiat de l'extrémité du circuit imprimé située dans la partie tubulaire du corps au niveau de sa surface évasée non polie (17).

3. Organe de signalisation selon la revendication 1, **caractérisé par le fait que** le corps (13) présente une surface non polie (18) connexe à la surface évasée non polie (17), plus largement évasée que celle-ci et située entre celle-ci et l'organe diffuseur translucide (12a,12b) engendrant le faisceau utile.

4. Organe de signalisation selon la revendication 1, **caractérisé par le fait que** l'organe diffuseur translucide (12) est mobile selon la direction longitudinale (X-X') du corps.

5. Ensemble d'organes de signalisation tels que voyants ou boutons-poussoirs lumineux selon l'une des revendications 1 à 4.

## Patentansprüche

1. Anzeigeorgan, wie beispielsweise eine Anzeigelampe oder ein Leuchtdruckknopf, mit einem eine Längsachse (X-X') aufweisenden und mit einem Kopf (11) endenden Körper (13), der ein durchsichtiges Verteilungsorgan (12) aufweist, aus dem ein nützlicher Lichtstrahl (F2) austritt, sowie mit einer eine Leuchtdiode (21) tragenden gedruckten Schaltung (20), die den Sendestrahl (F1) herstellt, der den nützlichen Strahl erzeugt,
**dadurch gekennzeichnet, daß**:
- die Leuchtdiode (21) seitlich auf der Oberfläche einer Seite (20a) der gedruckten Schaltung (20) montiert ist, so daß ihr Sendestrahl (F1) nach einer Richtung (Y-Y') ausgerichtet ist, die etwa lotrecht zur Längsachse (X-X') des Körpers (13) verläuft,
- der Körper (13) einen im allgemeinen rohrförmigen Teil aufweist, der in seinem Inneren und gegenüber der seitlichen Diode (21) eine nicht polierte konisch erweiterte Fläche umfaßt.

2. Anzeigeorgan nach dem Anspruch 1, **dadurch gekennzeichnet, daß** die Leuchtdiode (21) auf der gedruckten Schaltung (20) in der unmittelbaren Nachbarschaft des Endes der gedruckten Schaltung montiert ist, das sich im rohförmigen Teil des Körpers an seiner nicht polierten konisch erweiterten Fläche (17) befindet.

3. Anzeigeorgan nach dem Anspruch 1, **dadurch gekennzeichnet, daß** der Körper (13) eine nicht polierte Fläche (18) aufweist, die sich der nicht polierten konisch erweiterten Fläche (17) anschließt, eine größere Erweiterung als die letztere aufweist und die sich zwischen dieser und dem durchsichtigen Verteilerorgan (12a, 12b) befindet, das den nützlichen Strahl erzeugt.

4. Anzeigeorgan nach dem Anspruch 1, **dadurch gekennzeichnet, daß** das durchsichtige Verteilerorgan (12) nach der Längsrichtung (X-X') des Körpers mobil ist.

5. Einheit von Anzeigeorganen, wie beispielsweise Anzeigelampen oder Leuchtdruckknöpfe, nach einem der Ansprüche 1 bis 4.

## Claims

1. Signaling device such as an indicating light or a light push button comprising a body (13) with a longitudinal axis (X-X') and terminated by a head (11) that comprises a translucid diffusion device (12) from which a useful light beam (F2) is emitted, and a printed circuit (20) supporting a light emitting diode (21) that generates an emission beam (F1) producing the useful beam,
***characterized in that**:*
- the light emitting diode (21) is surface mounted on one side (20a) of the printed circuit (20) such that the direction (Y-Y') of its emission beam (F1) is approximately perpendicular to the longitudinal axis (X-X') of the body (13),
- one part of the body (13) has a generally tubular shape with an unpolished flared inside surface (17), facing the lateral diode (21).

2. Signaling device according to claim 1, **characterized in that** the light emitting diode (21) is mounted on the printed circuit (20) immediately adjacent to the end of the printed circuit located in the tubular part of the body at the same level as its unpolished flared surface (17).

3. Signaling device according to claim 1, **characterized in that** the body (13) has an unpolished surface (18) connected to the unpolished flared surface (17), more flared that the latter surface and located between it and the translucid diffusing device (12a, 12b) generating the useful beam.

4. Signaling device according to claim 1, **characterized in that** the translucid diffusing device (12) can move along the longitudinal direction (X-X') of the body.

5. Set of signaling devices such as indicating lights or light push buttons according to one of claims 1 to 4.
